(19) Europäisches Patentamt
European Patent Office
Office européen des brevets

(11) EP 4 779 868 A1

(12) EUROPEAN PATENT APPLICATION

(43) Date of publication:
22.07.2026 Bulletin 2026/30

(21) Application number: 25209858.7

(22) Date of filing: 20.10.2025

(51) International Patent Classification (IPC):
H03F 3/30 (2006.01)          H03F 1/08 (2006.01)
H03F 1/02 (2006.01)          H03F 3/19 (2006.01)
H03F 3/45 (2006.01)          H03F 3/50 (2006.01)

(52) Cooperative Patent Classification (CPC):
H03F 3/45197; H03F 1/02; H03F 1/086; H03F 3/19;
H03F 3/3022; H03F 3/505; H03F 2200/451;
H03F 2200/513; H03F 2203/30024;
H03F 2203/30027; H03F 2203/30031;
H03F 2203/30063; H03F 2203/30069;
H03F 2203/30144

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 15.01.2025 US 202563745397 P
08.10.2025 US 202519352493

(71) Applicant: MEDIATEK INC.
Hsinchu City 30078 (TW)

(72) Inventors:
• HUANG, Po-Chao
30078 Hsinchu City (TW)
• HUNG, Chia-Tse
30078 Hsinchu City (TW)

(74) Representative: Hoefer & Partner Patentanwälte
mbB
Pilgersheimer Straße 20
81543 München (DE)

(54) **TRANSIMPEDANCE AMPLIFIER WITH LOW SUPPLY VOLTAGE**

(57) The present invention provides a circuitry (100) including a TIA stage (120). The TIA stage (120) is configured to receive a current signal (Iin) to generate an output voltage signal (Vout), wherein the TIA stage (120) includes a first transistor (M2), a second transistor (M3) and a high-pass filter (124). A gate electrode of the first transistor (M2) is coupled to the current signal, and the first electrode of the transistor is coupled to a supply voltage. The second transistor (M3) has a gate electrode, a first electrode and a second electrode, wherein the first electrode of the second transistor is coupled to the second electrode of the first transistor, and the second electrode of the second transistor is coupled to a ground voltage. The high-pass filter (124) is configured to filter the current signal (Iin) to generate a filtered current signal to the gate electrode of the second transistor (M3).

FIG. 1

EP 4 779 868 A1

**Description**

Field of the Invention

The present invention relates to a circuitry comprising a transimpedance amplifier stage.

Background of the Invention

In modern high-speed communication systems and various electronic devices, the demand for energy-efficient signal processing circuits has become paramount. One such circuit that has been widely adopted due to its excellent energy efficiency and high sensitivity is the gm-TIA (transconductance - transimpedance amplifier) circuit. This type of amplifier is commonly employed in a variety of applications, such as linear equalizers.

A conventional gm-TIA circuit typically comprises a transconductance stage and a transimpedance amplifier (TIA) stage. The transconductance stage converts an input voltage signal into a corresponding current signal, which is then fed into the TIA stage. The TIA stage subsequently converts this current signal into a voltage signal, providing the necessary gain and bandwidth for the system.

However, as the semiconductor industry continues to advance towards more sophisticated process technologies, these advanced processes are often characterized by a continuous reduction in the supply voltage to mitigate power consumption and prevent device breakdown. For instance, in some processes, the supply voltage may be below 0.85V which cause a critical problem for conventional gm-TIA circuits, specifically concerning headroom limitations.

The headroom problem arises from the circuit's architecture. Both the transconductance stage and the TIA stage in a conventional gm-TIA circuit often require their own current sources to ensure proper operation. Furthermore, the total voltage drop across the cascoded components within the gm-TIA circuit must be less than the available supply voltage. As the supply voltage decreases, the voltage budget available for these cascoded components becomes increasingly constrained. In addition, the insufficient headroom can lead to several undesirable effects, including reduced output swing, degraded gain, and non-linear distortion. Therefore, designing a gm-TIA circuit that is suitable for operation under a low supply voltage is a significant challenge.

Summary of the Invention

Therefore, one of the objectives of the present invention is to provide a gm-TIA circuit that has greater headroom compared to prior art circuits, thereby solving the problems described in the prior art.

In one embodiment of the present invention, a circuitry comprising a transimpedance amplifier stage is disclosed. The transimpedance amplifier stage is configured to receive a current signal to generate an output voltage signal, wherein the transimpedance amplifier comprises a first transistor, a second transistor, a feedback resistor and a high-pass filter. The first transistor has a gate electrode, a first electrode and a second electrode, wherein the gate electrode of the first transistor is coupled to the current signal, and the first electrode of the first transistor is coupled to a supply voltage. The second transistor has a gate electrode, a first electrode and a second electrode, wherein the first electrode of the second transistor is coupled to the second electrode of the first transistor, and the second electrode of the second transistor is coupled to a ground voltage. The feedback resistor is coupled between an output terminal and an input terminal of the transimpedance amplifier stage, wherein the output terminal is a node between the second electrode of the first transistor and the first electrode of the second transistor. The high-pass filter is configured to filter the current signal to generate a filtered current signal to the gate electrode of the second transistor.

In one embodiment of the present invention, a circuitry comprising a transimpedance amplifier stage is disclosed. The transimpedance amplifier stage is configured to receive a current signal to generate an output voltage signal, wherein the transimpedance amplifier comprises a first transistor, a second transistor, a feedback resistor and a high-pass filter. The first transistor has a gate electrode, a first electrode and a second electrode, wherein the gate electrode of the first transistor is coupled to the current signal, and the first electrode of the first transistor is coupled to a supply voltage. The second transistor has a gate electrode, a first electrode and a second electrode, wherein the gate electrode of the second transistor is biased by a bias voltage, the first electrode of the second transistor is coupled to the second electrode of the first transistor, and the second electrode of the second transistor is coupled to a ground voltage. The feedback resistor is coupled between an output terminal and an input terminal of the transimpedance amplifier stage, wherein the output terminal is a node between the second electrode of the first transistor and the first electrode of the second transistor.

Brief Description of the Drawings

FIG. 1 is a schematic diagram illustrating a circuitry according to one embodiment of the present invention.
FIG. 2 is a frequency response of the circuitry shown in FIG. 1 according to one embodiment of the present invention.
FIG. 3 is a schematic diagram illustrating a circuitry according to one embodiment of the present invention.
FIG. 4 is a schematic diagram illustrating a circuitry according to one embodiment of the present invention.
FIG. 5 is a schematic diagram illustrating a circuitry according to one embodiment of the present invention.
FIG. 6 is a schematic diagram illustrating a circuitry according to one embodiment of the present invention.
FIG. 7 is a schematic diagram illustrating a TIA stage according to one embodiment of the present invention.
FIG. 8 is a schematic diagram illustrating a TIA stage according to one embodiment of the present invention.

Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

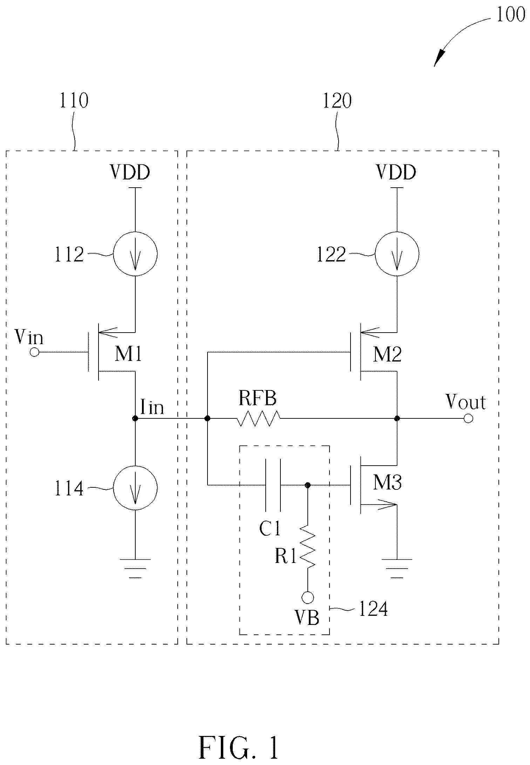

FIG. 1 is a schematic diagram illustrating a circuitry 100 according to one embodiment of the present invention. As shown in FIG. 1, the circuitry 100 is a gm-TIA circuit comprising a transconductance stage 110 and a TIA stage 120, wherein the transconductance stage 110 is configured to receive an input voltage signal Vin to generate a current signal Iin, and the TIA stage 120 is configured to receive the current signal Iin to generate an output voltage signal Vout.

The transconductance stage 110 comprises a transistor M1 and two current sources 112 and 114. The transistor M1 is implemented by a P-type transistor such as a P-type metal-oxide-semiconductor field-effect transistor (P-type MOSFET), wherein a gate electrode of the transistor M1 receives the input voltage signal, a source electrode of the transistor M1 is coupled to a supply voltage VDD via the current source 112, and a drain electrode of the transistor M1 is coupled to a ground voltage via the current source 114.

The TIA stage 120 comprises a current source 122, transistors M2 and M3, a feedback resistor RFB, and a high-pass filter 124 comprising a capacitor C1 and a resistor R1. The transistors M2 and M3 are implemented by using a P-type transistor and an N-type transistor, respectively. A gate electrode of the transistor M2 receives the current signal Iin, a source electrode of the transistor M2 is coupled to the supply voltage VDD via the current source 122, a drain electrode of the transistor M2 is coupled to a drain electrode of the transistor M3, and a source electrode of the transistor M3 is coupled to the ground voltage. A node between the drain electrode of the transistor M2 and the drain electrode of the transistor M3 serves as an output terminal of the TIA stage 120, and the feedback resistor RFB is coupled between an input terminal and the output terminal of the TIA stage 120. The high-pass filter 124 is coupled between the current signal Iin and a gate electrode of the transistor M3, that is, the transistor M3 receives a filtered current signal generated by the high-pass filter 124. In the high-pass filter 124, the capacitor C1 is coupled between the current signal Iin and the gate electrode of the transistor M3, and the resistor R1 is coupled between a bias voltage VB and the gate electrode of the transistor M3.

In the embodiment shown in FIG. 1, by adding the high-pass filter 124 at the gate electrode of the transistor M3, the circuitry 100 can have more headroom, so that the design of the TIA stage 120 becomes easier for the engineer. Specifically, the headroom criterion of the circuitry 100 is as follows:

$$V_{DS\_CS} + V_{GS\_M2} + V_{DS\_M3} < VDD \dots\dots\dots\dots(1).$$

Wherein "$V_{DS\_CS}$" is a drain-to-source voltage of the current source 122, "$V_{GS\_M2}$" is a gate-to-source voltage of the transistor M2, and "$V_{DS\_M3}$" is a drain-to-source voltage of the transistor M3. Since the terms "$V_{DS\_CS}$" and "$V_{DS\_M3}$" are small values, the circuitry 100 can work normally with lower supply voltage such as 0.85V.

In addition, if the TIA stage 120 does not have the high-pass filter 124 (i.e., conventional TIA), the term "$V_{DS\_M3}$" in the above formula will be replaced by a gate-to-source voltage of the transistor M3. This gate-to-source voltage is much larger than the drain-source voltage of transistor M3, which makes it difficult for the TIA stage 120 to operate at a lower supply voltage VDD.

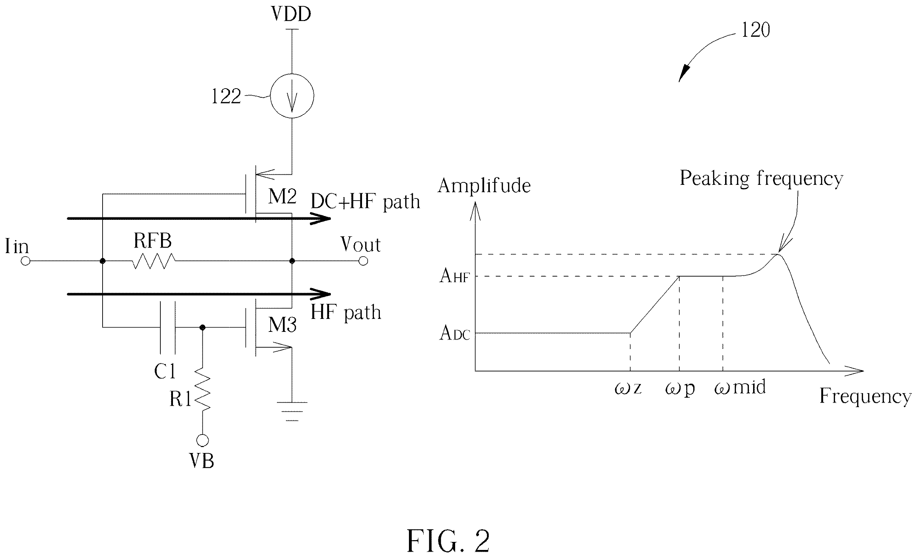

FIG. 2 is a frequency response of the circuitry 100 according to one embodiment of the present invention. As shown in FIG. 2, the TIA stage 120 has a DC path and high frequency path through the transistor M2, and a high frequency path through the transistor M3. The characteristics of the circuitry 100 are as follows:

$$\frac{Vout}{Iin} = \frac{(1 - gmp*RFB) + sC1[(1 - gmp*RFB - gmn*RFB)*R1]}{\left(\frac{1}{ro} + gmp\right) + sC1[1 + R1*\left(\frac{1}{ro} + gmp + gmn\right) + RFB/ro]} \dots\dots\dots\dots(2).$$

$$A_{DC} = \frac{1-gmp*R1}{\frac{1}{ro}+gmp} \quad \dots\dots\dots\dots\dots\dots\dots\dots\dots\dots\dots\dots\dots\dots\dots\dots\dots\dots\dots\dots\dots\dots\dots(3).$$

$$A_{HF} = \frac{(1-gmp*RFB-gmn*RFB)*R1}{1+R1*\left(\frac{1}{ro}+gmp+gmn\right)+RFB/ro} \quad \dots\dots\dots\dots\dots\dots\dots\dots\dots\dots\dots\dots\dots\dots\dots(4).$$

$$\omega_p = \frac{\frac{1}{ro}+gmp}{C1*[1+R1\left(\frac{1}{rp}+gmp+gmn\right)+RFB/ro]} \quad \dots\dots\dots\dots\dots\dots\dots\dots\dots\dots\dots\dots\dots(5).$$

$$\omega_z = \frac{1-gmp*RFB}{C1*[(1-gmp*RFB-gmn*RF)*C1]} \quad \dots\dots\dots\dots\dots\dots\dots\dots\dots\dots\dots\dots\dots\dots(6).$$

In the equations (2) - (6), "gmp" is a transconductance of the transistor M2, "gmn" is a transconductance of the transistor M3, and "ro" is an output impedance.

In the embodiment shown in FIG. 1 and FIG. 2, the circuitry 100 has low frequency equalization (LFEQ) effect, that is, the frequency response between frequencies $\omega_z$ and $\omega_{mid}$ is smooth, which is suitable for the linear equalizer.

In addition, by designing the high-pass filter 124 between the current signal Iin and the gate electrode of the transistor M3, and there is no high-pass filter positioned between the current signal Iin and the transistor M2, the circuitry 100 is robust to process-voltage-temperature (PVT) variation. Specifically, when the circuitry 100 suffers PVT variations, a voltage offset ΔVout of the output voltage signal Vout can be expressed as follows:

$$\Delta\text{Vout} \cong \Delta\text{Vthp} + \frac{gmn}{gmp} * \Delta Vthn \quad \dots\dots\dots\dots\dots\dots\dots\dots\dots\dots\dots\dots\dots\dots\dots\dots(7).$$

In the equation (7),"ΔVthp" is an offset of threshold voltage of the transistor M2, and "ΔVthn" is an offset of threshold voltage of the transistor M3. Referring to equation (7), the circuitry 100 is not sensitive to PVT variations.

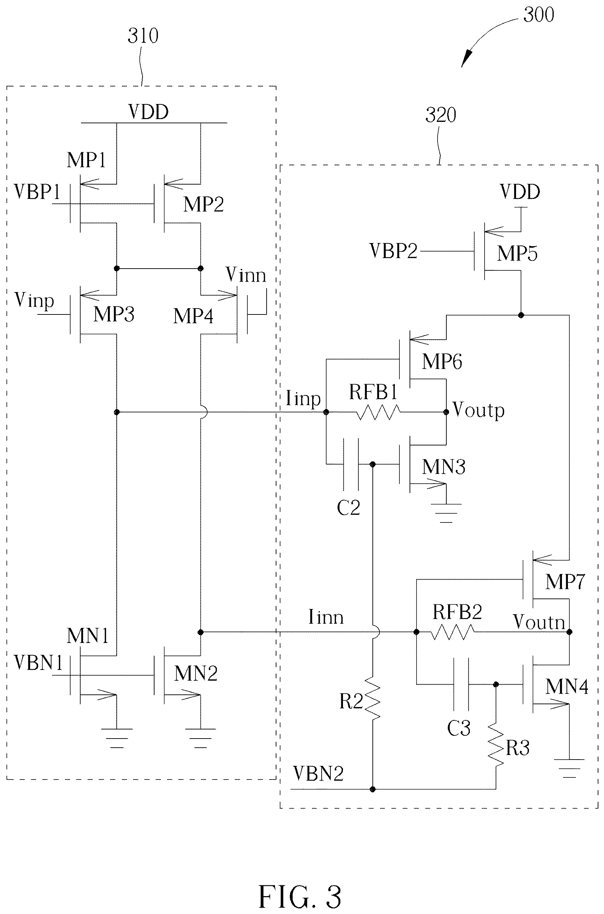

FIG. 3 is a schematic diagram illustrating a circuitry 300 according to one embodiment of the present invention. As shown in FIG. 3, the circuitry 300 is a gm-TIA circuit comprising a transconductance stage 310 and a TIA stage 320, wherein the transconductance stage 310 is configured to receive a differential input voltage signal Vinp and Vinn to generate a differential current signal Iinp and Iinn, and the TIA stage 320 is configured to receive the differential current signal Iinp and Iinn to generate a differential output voltage signal Voutp and Voutn.

The transconductance stage 310 comprises P-type transistors MP1 - MP4 and N-type transistors MN1 - MN2. The P-type transistors MP1 and MP2 are biased by a bias voltage VBP1 and serve as current sources. The N-type transistors MN1 and MN2 are biased by a bias voltage VBN1 and serve as current sources. Gate electrodes of the P-type transistors MP3 and MP4 are used to receive the differential input voltage signal Vinp and Vinn, source electrodes of the P-type transistors MP3 and MP4 are coupled to a supply voltage VDD via the P-type transistors MP1 and MP2, respectively, and drain electrodes of the P-type transistors MP3 and MP4 are coupled to a ground voltage via the N-type transistors MN1 and MN2, respectively.

The TIA stage 320 comprises a current source (implemented by a P-type transistor biased by a bias voltage VBP2), a first TIA circuit and a second TIA circuit, wherein the first TIA circuit comprises a P-type transistor MP6, an N-type transistor MN3, a feedback resistor RFB1, and a first high-pass filter comprising a capacitor C2 and a resistor R2; and the second TIA circuit comprises a P-type transistor MP7, an N-type transistor MN4, a feedback resistor RFB2, and a second high-pass filter comprising a capacitor C3 and a resistor R3. A gate electrode of the P-type transistor MP6 is used to receive the current signal Iinp, a source electrode of the P-type transistor MP6 is coupled to the supply voltage VDD via the current source MP5, a drain electrode of the P-type transistor MP6 is coupled to a drain electrode of the N-type transistor MN3, and a source electrode of the N-type transistor MN3 is coupled to the ground voltage. A node between the drain electrode of the P-type transistor MP6 and the drain electrode of the N-type transistor MN3 serves as an output terminal of the first TIA circuit, and the feedback resistor RFB1 is coupled between an input terminal and the output terminal of the first TIA circuit. The first high-pass filter is coupled between the current signal Iinp and a gate electrode of the N-type transistor MN3, that is, the N-type transistor MN3 receives a filtered current signal generated by the first high-pass filter. In the first high-pass filter, the capacitor C2 is coupled between the current signal Iinp and the gate electrode of the N-type transistor MN3, and the resistor R2 is coupled between a bias voltage VBN2 and the gate electrode of the N-type transistor MN3. Regarding the second TIA circuit, a gate electrode of the P-type transistor MP7 is used to receive the current signal Iinn, a source electrode of the P-type transistor MP7 is coupled to the supply voltage VDD via the current source MP5, a drain electrode of the P-type transistor MP7 is coupled to a drain electrode of the N-type transistor MN4, and a source electrode of the N-type transistor MN4 is coupled to the ground voltage. A node between the drain electrode of the P-type transistor MP7 and the drain electrode of the N-type transistor MN4 serves as an output terminal of the second TIA circuit, and the feedback resistor RFB2 is coupled between an input terminal and the output terminal of the second TIA circuit. The second high-pass filter is coupled between the current signal Iinn and a gate electrode of the N-type transistor MN4, that is N-type transistor MN4 receives a filtered current signal generated by the second high-pass filter. In the second high-pass filter, the capacitor C3 is coupled between the current signal Iinn and the gate electrode of the N-type transistor MN4, and the resistor R3 is coupled between the bias voltage VBN2 and the gate electrode of the N-type transistor MN4.

In one embodiment, the bias voltage VBN2 can be implemented by using a common mode voltage of the differential output voltage signal Voutp and Voutn.

Similar to the embodiment shown in FIG. 1, by adding the first high-pass filter including the capacitor C2 and the resistor R2 at the gate electrode of the N-type transistor MN3, and by adding the second high-pass filter including the capacitor C3 and the resistor R3 at the gate electrode of the N-type transistor MN4, the circuitry 300 can have more headroom, so that the design of the TIA stage 320 becomes easier for the engineer. In addition, the circuitry 300 has LFEG effect, as shown in FIG. 2, which is suitable for the linear equalizer.

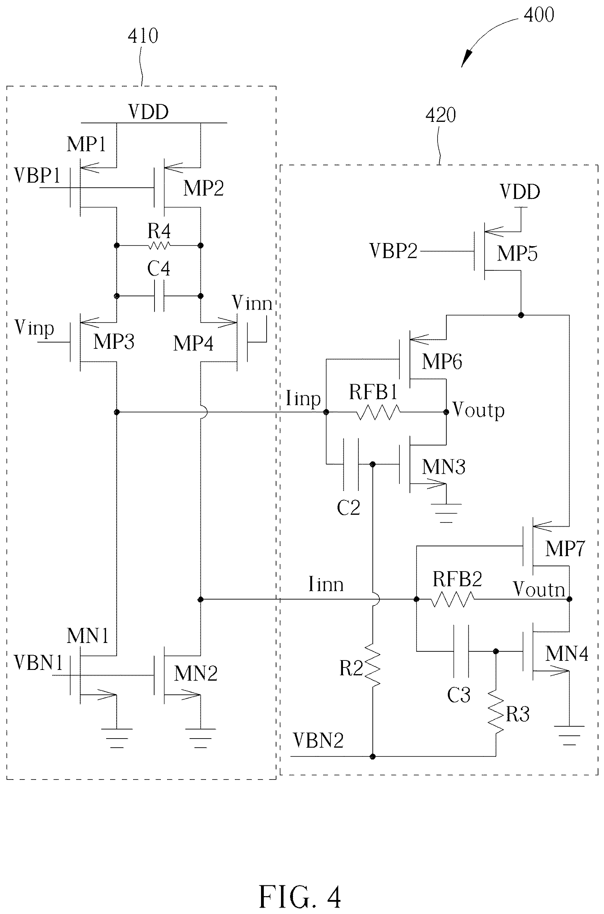

FIG. 4 is a diagram illustrating a circuitry 400 according to one embodiment of the present invention. As shown in FIG. 4, the circuitry 400 is a gm-TIA circuit comprising a transconductance stage 410 and an TIA stage 420, wherein the transconductance stage 410 is configured to receive a differential input voltage signal Vinp and Vinn to generate a differential current signal Iinp and Iinn, and the TIA stage 420 is configured to receive the differential current signal Iinp and Iinn to generate a differential output voltage signal Voutp and Voutn. The transconductance stage 410 differs from the transconductance stage 310 in FIG. 3 only by the addition of an RC degeneration circuit (resistor R4 and capacitor C4). Since the architecture of the TIA stage 420 is the same as the TIA stage 320 in FIG. 3, a person skilled in the art should be able to understand the operation of the circuitry 400 after reading the preceding embodiments.

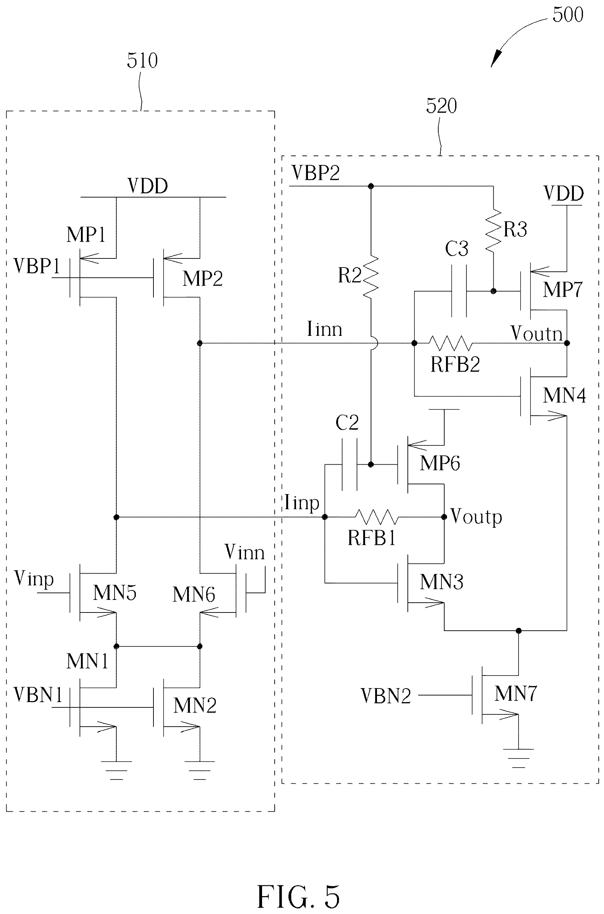

FIG. 5 is a diagram illustrating a circuitry 500 according to one embodiment of the present invention. As shown in FIG. 5, the circuitry 500 is a gm-TIA circuit comprising a transconductance stage 510 and an TIA stage 520, wherein the transconductance stage 510 is configured to receive a differential input voltage signal Vinp and Vinn to generate a differential current signal Iinp and Iinn, and the TIA stage 520 is configured to receive the differential current signal Iinp and Iinn to generate a differential output voltage signal Voutp and Voutn. The transconductance stage 510 differs from the transconductance stage 310 in FIG. 3 only by using N-type transistors MN5 and MN6 as an input pair, and the TIA stage 710 differs from the transconductance stage 310 in FIG. 3 only by using N-type transistor MN7 as current source. Since the main architecture of the circuitry 500 is the same as the circuitry 300 in FIG. 3, a person skilled in the art should be able to understand the operation of the circuitry 500 after reading the preceding embodiments.

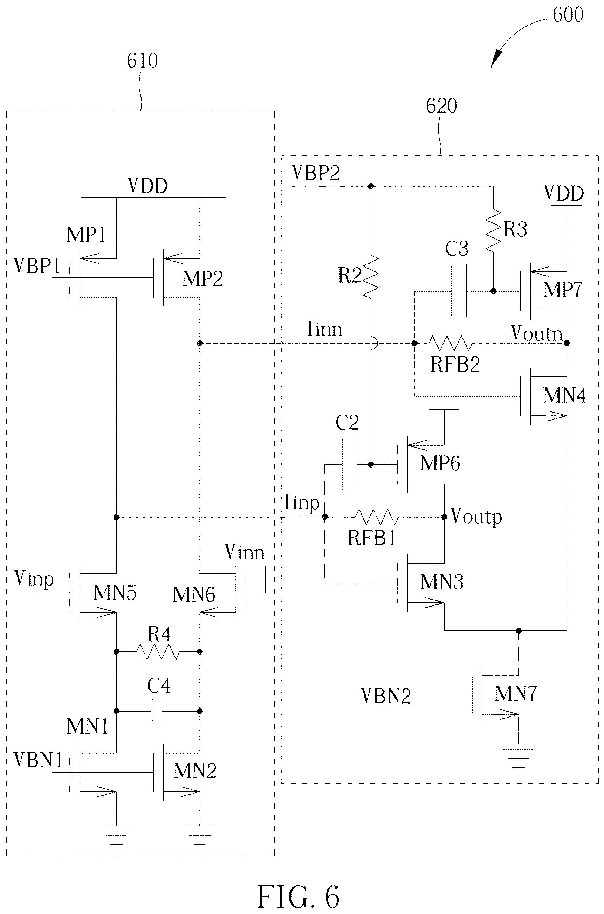

FIG. 6 is a diagram illustrating a circuitry 600 according to one embodiment of the present invention. As shown in FIG. 6, the circuitry 600 is a gm-TIA circuit comprising a transconductance stage 610 and an TIA stage 620, wherein the transconductance stage 610 is configured to receive a differential input voltage signal Vinp and Vinn to generate a differential current signal Iinp and Iinn, and the TIA stage 620 is configured to receive the differential current signal Iinp and Iinn to generate a differential output voltage signal Voutp and Voutn. The transconductance stage 610 differs from the transconductance stage 510 in FIG. 5 only by the addition of an RC degeneration circuit (resistor R4 and capacitor C4). Since the main architecture of the circuitry 600 is the same as the circuitry 500 in FIG. 5, a person skilled in the art should be able to understand the operation of the circuitry 600 after reading the preceding embodiments.

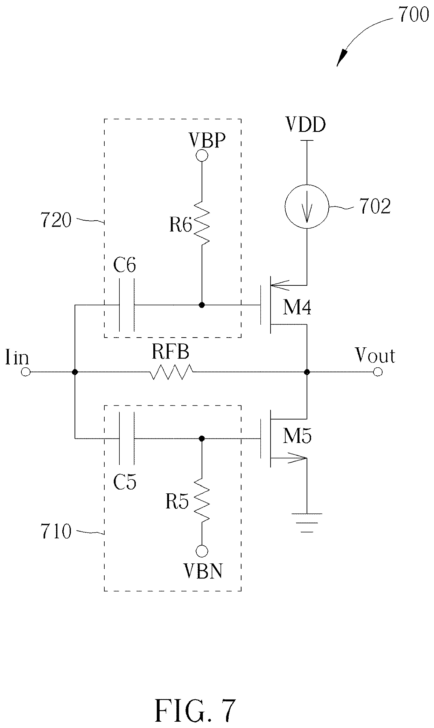

FIG. 7 is a schematic diagram illustrating a TIA stage 700 according to one embodiment of the present invention, wherein the TIA stage 700 can be used to replace the TIA stage 120 shown in FIG. 1. As shown in FIG. 7, the TIA stage 700 is configured to receive a current signal Iin to generate an output voltage signal Vout. The TIA stage 700 comprises a current source 702, transistors M4 and M5, a feedback resistor RFB, a high-pass filter 710 comprising a capacitor C5 and a resistor R5, and a high-pass filter 720 comprising a capacitor C6 and a resistor R6. The transistors M4 and M5 are implemented by using P-type transistor and N-type transistor, respectively. A gate electrode of the transistor M4 receives the current signal Iin, a source electrode of the transistor M4 is coupled to the supply voltage VDD via the current source 702, a drain electrode of the transistor M4 is coupled to a drain electrode of the transistor M5, and a source electrode of the transistor M5 is coupled to the ground voltage. A node between the drain electrode of the transistor M4 and the drain electrode of the transistor M5 serves as an output terminal of the TIA stage 700, and the feedback resistor RFB is coupled between an input terminal and the output terminal of the TIA stage 700. The high-pass filter 710 is coupled between the current signal Iin and a gate electrode of the transistor M5, that is, the transistor M5 receives a filtered current signal generated by the high-pass filter 710. In the high-pass filter 710, the capacitor C5 is coupled between the current signal Iin and the gate electrode of the transistor M5, and the resistor R5 is coupled between a bias voltage VBN and the gate electrode of the transistor M5. The high-pass filter 720 is coupled between the current signal Iin and a gate electrode of the transistor M4, that is, the transistor M4 receives a filtered current signal generated by the high-pass filter 720. In the high-pass filter 720, the capacitor C6 is coupled between the current signal Iin and the gate electrode of the transistor M4, and the resistor R6 is coupled between a bias voltage VBP and the gate electrode of the transistor M4.

In the embodiment shown in FIG. 7, by adding the high-pass filter 710 at the gate electrode of the transistor M5, and by adding the high-pass filter 720 at the gate electrode of the transistor M4, the circuitry including the TIA stage 700 can have more headroom, so that the design of the TIA stage 700 becomes easier for the engineer. In addition, compared to the embodiment in FIG. 1, the TIA stage 700 can operate at a lower supply voltage, but it will be more sensitive to PVT variation.

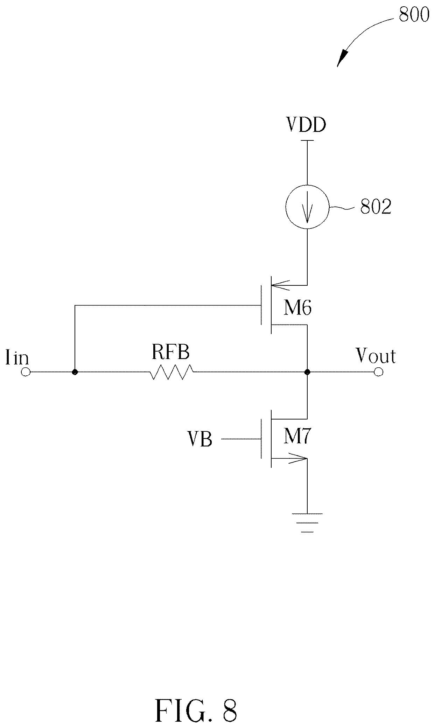

FIG. 8 is a schematic diagram illustrating a TIA stage 800 according to one embodiment of the present invention, wherein the TIA stage 800 can be used to replace the TIA stage 120 shown in FIG. 1. As shown in FIG. 8, the TIA stage 800 is configured to receive a current signal Iin to generate an output voltage signal Vout. The TIA stage 800 comprises a current source 802, transistors M6 and M7, and a feedback resistor RFB. The transistors M6 and M7 are implemented by using P-type transistor and N-type transistor, respectively. A gate electrode of the transistor M6 is used to receive the current signal Iin, a source electrode of the transistor M6 is coupled to the supply voltage VDD via the current source 802, a drain electrode of the transistor M6 is coupled to a drain electrode of the transistor M7, and a source electrode of the transistor M7 is coupled to the ground voltage. A node between the drain electrode of the transistor M6 and the drain electrode of the transistor M7 serves as an output terminal of the TIA stage 800, and the feedback resistor RFB is coupled between an input terminal and the output terminal of the TIA stage 800. In this embodiment, a gate electrode of the transistor is biased by a bias voltage VB, that is, the transistor M7 can be regarded as a current source.

In the embodiment shown in FIG. 8, by applying the bias voltage VB to the gate electrode of the transistor M7, the circuitry including the TIA stage 800 can have more headroom, so that the design of the TIA stage 800 becomes easier for the engineer.

**Claims**

1.  A circuitry (100), comprising:
    a transimpedance amplifier stage (120, 700), configured to receive a current signal (Iin) to generate an output voltage signal (Vout), wherein the transimpedance amplifier stage (120, 700) comprises:

    a first transistor (M2, M4) having a gate electrode, a first electrode and a second electrode, wherein the gate electrode of the first transistor (M2, M4) is coupled to the current signal (Iin), and the first electrode of the first transistor (M2, M4) is coupled to a supply voltage (VDD);
    a second transistor (M3, M5) having a gate electrode, a first electrode and a second electrode, wherein the first electrode of the second transistor (M3, M5) is coupled to the second electrode of the first transistor (M2, M4), and the second electrode of the second transistor (M3, M5) is coupled to a ground voltage;
    a feedback resistor (RFB), coupled between an output terminal and an input terminal of the transimpedance amplifier stage (120), wherein the output terminal is a node between the second electrode of the first transistor (M2, M4) and the first electrode of the second transistor (M3, M5); and
    a high-pass filter (124, 710), configured to filter the current signal (Iin) to generate a filtered current signal to the gate electrode of the second transistor (M3, M5).

2.  The circuitry (100) of claim 1, wherein there is no high-pass filter positioned between the current signal (Iin) and the gate electrode of the first transistor (M2).

3.  The circuitry (100) of claim 1 or 2, wherein the first transistor is a P-type transistor (M2, M4), and the second transistor is an N-type transistor (M3, M5).

4.  The circuitry (100) of any of claims 1-3, wherein the high-pass filter (124, 710) comprises:

    a capacitor (C1, C5), coupled between the current signal (Iin) and the gate electrode of the second transistor (M3, M5); and
    a resistor (R1, R5), coupled between a bias voltage and the gate electrode of the second transistor (M3, M5).

5.  The circuitry (100) of any of claims 1-4, wherein the transimpedance amplifier stage (120, 700) further comprises:
    a current source (122, 702), coupled between the first electrode of the first transistor (M2, M4) and the supply voltage (VDD).

6.  The circuitry (100) of claim 1, wherein the high-pass filter is a first high-pass filter (710), the filtered current signal generated by the first high-pass filter (710) is a first filtered current signal, and the circuitry (100) further comprises:
    a second high-pass filter (720), configured to filter the current signal (Iin) to generate a second filtered current signal to the gate electrode of the first transistor (M4).

7. The circuitry (100) of claim 6, wherein the first high-pass filter (710) comprises:

a first capacitor (C5), coupled between the current signal (Iin) and the gate electrode of the second transistor (M5); and
a first resistor (R5), coupled between a first bias voltage and the gate electrode of the second transistor (M5); and
the second high-pass filter (720) comprises:

a second capacitor (C6), coupled between the current signal (Iin) and the gate electrode of the first transistor (M4); and
a second resistor (R6), coupled between a second bias voltage and the gate electrode of the first transistor (M4).

8. The circuitry (100) of any of claims 1-7, further comprising:
a transconductance stage (110), configured to receive an input voltage signal (Vin) to generate the current signal (Iin) to the transimpedance amplifier stage (120, 700).

9. A circuitry (100), comprising:

a transimpedance amplifier stage (800), configured to receive a current signal (Iin) to generate an output voltage signal (Vout), wherein the transimpedance amplifier stage (800) comprises:

a first transistor (M6) having a gate electrode, a first electrode and a second electrode, wherein the gate electrode of the first transistor (M6) is coupled to the current signal (Iin), and the first electrode of the first transistor (M6) is coupled to a supply voltage (VDD);
a second transistor (M7) having a gate electrode, a first electrode and a second electrode, wherein the gate electrode of the second transistor (M7) is biased by a bias voltage (VB), the first electrode of the second transistor (M7) is coupled to the second electrode of the first transistor (M6), and the second electrode of the second transistor (M7) is coupled to a ground voltage;
a feedback resistor (RFB), coupled between an output terminal and an input terminal of the transimpedance amplifier stage (800), wherein the output terminal is a node between the second electrode of the first transistor (M6) and the first electrode of the second transistor (M7).

10. The circuitry (100) of claim 9, wherein the first transistor is a P-type transistor (M6), and the second transistor is an N-type transistor (M7).

11. The circuitry (100) of claim 9 or 10, wherein the transimpedance amplifier stage (800) further comprises:
a current source (802), coupled between the first electrode of the first transistor (M6) and the supply voltage (VDD).

12. The circuitry (100) of any of claims 9-11, further comprising:
a transconductance stage (110), configured to receive an input voltage signal (Vin) to generate the current signal (Iin) to the transimpedance amplifier stage (800).

FIG. 1

FIG. 2

EP 4 779 868 A1

FIG. 3

FIG. 4

FIG. 5

FIG. 6

700

VBP

720

R6

C6

VDD

702

M4

Iin

RFB

Vout

C5

M5

R5

710

VBN

FIG. 7

800

VDD

802

M6

Iin    RFB    Vout

VB    M7

FIG. 8

**EUROPEAN SEARCH REPORT**

Application Number

EP 25 20 9858

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/315621 A1 (NARATHONG CHIEWCHARN [US] ET AL) 24 December 2009 (2009-12-24) | 1-5,9-11 | INV.<br>H03F3/30 |
| A | * paragraphs [0001] - [0064]; figures 1-9 * | 6-8,12 | H03F1/08<br>H03F1/02<br>H03F3/19 |
| X | US 2016/359459 A1 (ZHU JIANXUN [US] ET AL) 8 December 2016 (2016-12-08) | 1,3,4,6-9,12 | H03F3/45<br>H03F3/50 |
| A | * paragraphs [0002] - [0039]; figures 1-7 * | 5,10,11 | |

TECHNICAL FIELDS
SEARCHED (IPC)

H03F

The present search report has been drawn up for all claims

| Place of search | Date of completion of the search | Examiner |
|---|---|---|
| The Hague | 19 March 2026 | Fedi, Giulio |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 20 9858

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2026

| Patent document cited in search report | Publication date | Patent family member(s) | | Publication date |
|---|---|---|---|---|
| US 2009315621 A1 | 24-12-2009 | CN | 102067443 A | 18-05-2011 |
| | | EP | 2340612 A1 | 06-07-2011 |
| | | JP | 5479464 B2 | 23-04-2014 |
| | | JP | 2011525338 A | 15-09-2011 |
| | | KR | 20110022066 A | 04-03-2011 |
| | | TW | 201004132 A | 16-01-2010 |
| | | US | 2009315621 A1 | 24-12-2009 |
| | | WO | 2009155566 A1 | 23-12-2009 |
| US 2016359459 A1 | 08-12-2016 | US | 2016359459 A1 | 08-12-2016 |
| | | WO | 2015163971 A2 | 29-10-2015 |

For more details about this annex : see Official Journal of the European Patent Office, No. 12/82

EPO FORM P0459